# EUROPÄISCHE PATENTSCHRIFT

(11) **EP 1 006 655 B1**
(45) Veröffentlichungstag und Bekanntmachung des Hinweises auf die Patenterteilung: **01.03.2006**
(21) Anmeldenummer: 99123563.1
(22) Anmeldetag: 26.11.1999
(51) Int. Cl.: H03K 17/082, H03K 17/18

(54) **Schutzschaltung für einen Leistungshalbleiter**
Protection circuit for a power semiconductor
Circuit de protection pour un semi-conducteur de puissance

(30) Priorität: 01.12.1998 DE 19855370
(43) Veröffentlichungstag der Anmeldung: 07.06.2000
(73) Patentinhaber: ROBERT BOSCH GMBH, 70442 Stuttgart (DE)
(72) Erfinder: Grimm, Andreas, 76316 Malsch (DE)

(56) Entgegenhaltungen:
- WO-A-98/35441
- WO-A-99/03184
- DD-A- 116 105
- DE-A- 19 501 373
- "SMARTPOWER RISIKOARM BAUEN" ELEKTRONIKPRAXIS, VOGEL, WUERZBURG, DE, Bd. 29, Nr. 15/16, 25. August 1994 (1994-08-25), Seiten 26,28-29, XP009008875 ISSN: 0341-5589

## Beschreibung

### Stand der Technik

Die Erfindung betrifft eine Schutzschaltung für einen Leistungshalbleiter, der einen integrierten Sensor zum Überwachen eines Betriebsparameters auf Überlastung und zum Abschalten des Leistungshalbleiters beim Erreichen oder Überschreiten eines vorgegebenen Überlastwertes des Betriebsparameters aufweist und den Abschaltezustand auf einem Diagnoseausgang anzeigt.

Am Diagnoseausgang tritt ein Ausgangssignal auf, wenn der Sensor aufgrund des Überlastwertes des Betriebsparameters anspricht und sich selbst abschaltet. Der Überlastschutz, als Übertemperaturschutz oder Überlastschutz, ist dabei in den Leistungshalbleiter integriert und bildet mit diesem einen handelsüblichen Baustein. Der Nachteil derartiger Leistungshalbleiter mit integrierter Schutzfunktion besteht nun darin, dass der Zeitpunkt der Abschaltung nicht bekannt ist und dadurch zu einem beliebigen Zeitpunkt eine Sicherheitsfunktion durch die Abschaltung des Leistungshalbleiters abgebrochen werden kann.

Es ist Aufgabe der Erfindung, eine Schutzschaltung für einen Leistungshalbleiter der eingangs erwähnten Art zu schaffen, die schon rechtzeitig vor dem selbsttätigen Abschalten des Leistungshalbleiters reagiert und vor dem Abschalten noch die Durchführung einer notwendigen Sicherheitsfunktion zuläßt.

Diese Aufgabe wird nach der Erfindung dadurch gelöst, dass der Sensor bei einem Wert des Betriebsparameters, der einen vorgegebenen Betrag unterhalb des Überlastwertes liegt, auf dem Diagnoseausgang ein Vorwarnsignal abgibt, das sich vom Abschaltsignal unterscheidet, und dass das Vorwarnsignal einem Mikrokontroller zugeführt wird, der die Ansteuerung des Leistungshalbleiters in vorgegebener Weise kontrolliert weiterführt und/oder verzögert beendet.

Mit der zusätzlichen Ansprechschwelle der Sensoren kann an dem Diagnoseausgang eine Frühinformation für eine zu erwartende Abschaltung des Leistungshalbleiters erhalten werden, die zu einer Durchführung einer notfalls auszuführenden Notfunktion ausgenutzt werden kann. So kann z.B. bei einem Fensterheber oder einem Schiebedach noch rechtzeitig vor der Abschaltung des Antriebes, der durch das selbsttätige Abschalten des Leistungshalbleiters bewirkt wird, die Einstellung des Schließzustandes bewirkt werden.

Der Sensor kann als Temperatursensor oder als Lastsensor ausgebildet sein, wobei als Ansprechschwellen die Temperatur oder der Strom verwendet wird. Als Schwellwert kann auch eine neue Zeitvorgabe gewählt werden.

Ist vorgesehen, dass im Ruhezustand und im Abschaltzustand des Sensors auf dem Diagnoseausgang unterschiedliche, statische Signale anstehen und dass als Vorwarnsignal ein getaktetes Signal ansteht, dann kann auf einfache Weise durch den Mikrokontroller nach Ruhezustand = ordnungsgemäßer Betrieb und Abschaltzustand des Leistungshalbleiters unterschieden werden. Das getaktete Vorwarnsignal gibt den zu erwartenden Abschaltefall an und wird vom Sensor gebildet und vom Mikrokontroller ausgewertet, der dann seine Sonderfunktion in Form einer vorgegebenen Ansteuerung des Leistungshalbleiters übernimmt.

Anstelle eines einzigen Sensors im Leistungshalbleiter kann nach einer weiteren Ausgestaltung vorgesehen sein, dass der Leistungshalbleiter mehrere unterschiedliche Sensoren enthält, die auf getrennte Diagnoseausgänge oder einen gemeinsamen Diagnoseausgang arbeiten. Dabei spielt es in der Regel für den Mikrokontroller keine Rolle von welchem Sensor das Vorwarnsignal abgegeben wird.

Wenn die Vorwarnsignale der Sensoren jedoch unterschiedliche Notfunktionen bewirken sollen, dann werden die Vorwarnsignale über separate Diagnoseausgänge dem Mikrocontroller zugeführt, damit dieser die Herkunft der Vorwarnsignale erkennt und entsprechend unterschiedlich reagieren kann.

Ist der Leistunshalbleiter im Taktbetrieb gesteuert, dann kann eine Ausgestaltung von Vorteil sein, die dadurch gekennzeichnet ist, dass ein im Taktbetrieb gesteuerter Leistungshalbleiter mit dem Auftreten des Vorwarnsignals über den Mikrokontroller vorzugsweise zeitlich begrenzt im Dauerbetrieb ansteuerbar und dann abschaltbar ist. Wenn der Leistungshalbteiters einen Motor steuert, dann kann dieser oder ein davon betriebener Antriebsmechanismus bei voller Durchsteuerung des Leistungshalbleiter im Schnellgang in eine definierte Endstellung gebracht werden.

Von Vorteil ist auch eine Weiterbildung, die dadurch gekennzeichnet ist, dass die Ansprechwerte für die Sensoren zur Abgabe eines Vorwarnsignals durch eine externe Beschaltung des Leistungshalbleiters einstellbar ist. Die Schutzschaltung ist dann auf unterschiedliche Betriebsdaten einstellbar.

Die Erfindung wird anhand eines als Schaltprinzip dargestellten Ausführungsbeispiels näher erläutert.

Der angegebene Leistungshalbleiter in Form eines Power-MOS-FET T eines ist mit einem Sensor TS oder einem Überlastsensor JS versehen, der in dem Leistungshalbleiter integriert ist und einen Diagnoseausgang dp1 oder dp2 aufweist. Der Leistungshalbleiter kann auch mehrere unterschiedliche Sensoren integriert haben, wie das Ausführungsbeispiel mit einem Temperatursensor TS und einem Überlastsensor zeigt. Der Power-MOS-FET T ist ein N-Kanal-Power-MOS-FET, der einen Verbraucher V steuert, wobei über die Ansteuerschaltung AS ein Taktbetrieb oder ein Dauerbetrieb möglich ist. Die in dem Power-MOS-FET T integrierten Sensoren TS bzw. JS geben beim Erreichen oder Überschreiten einer vorgegebenen Überlastungstemperatur oder Überlastungsstrom ein Abschalttsignal auf dem Diagnoseausgang dp1 bzw. dp2. Steht im ordnungsgemäßen Betriebszustand = Ruhezustand des Diagnoseausgangs ein Signal "0" an, dann zeigt das Signal "1" den Abschaltzustand des Power-MOS-FET T an. Dabei können beide Sensoren TS und JS auch auf einem gemeinsamen Diagnoseausgang arbeiten. Getrennte Diagnoseausgänge dp1 und dp2 sind dann sinnvoll, wenn der Miktrocontroller µC unterschiedlich auf die auftretenden Vorwarnsignale reagieren muß.

Eine verbesserte Schutzfunktion für den Power-MOS-FET T1 wird dadurch erreicht, dass der oder die Sensoren TS, JS eine zusätzliche Ansprechschwelle aufweisen, die kleiner ist als der Überlastwert des überwachten Betriebsparameters. Damit kann ein bevorstehender Abschaltefall, der ja beim Überlastwert selbsttätig vom Power-MOS-FET T ausgeführt wird, angekündigt werden. Dazu tritt ein vorzugsweise getaktetes Vorwarnsignal auf dem Diagnoseausgang dp1 bzw. dp2 auf, das der angeschaltete Mikrocontroller µC leicht vom Abschaltdauersignal unterscheiden kann. Der Miktrocontroller µC leitet dann über die Ansteuerschaltung AS eine kontrollierte Abschaltung des Power-MOS-FET T ein, die auch mit einer bestimmten Verzögerung vorgenommen werden kann. Der im Taktbetrieb gesteuerte Power-MOS-FET T kann im Vorwarnzustand auch vom Mikrocontroller µC voll durchgesteuert und im Maximallastbetrieb betrieben werden. Dies ist besonders dann von Interesse, wenn der Power-MOS-FET T einen Motor als Verbraucher V steuert, der dann noch in eine definierte Endstellung gebracht werden muß. Dabei kann zur endgültigen Abschaltung auch ein Endschalter des Motors oder des vom Motor gesteuerten Antriebes oder Gerätes ausgenutzt werden.

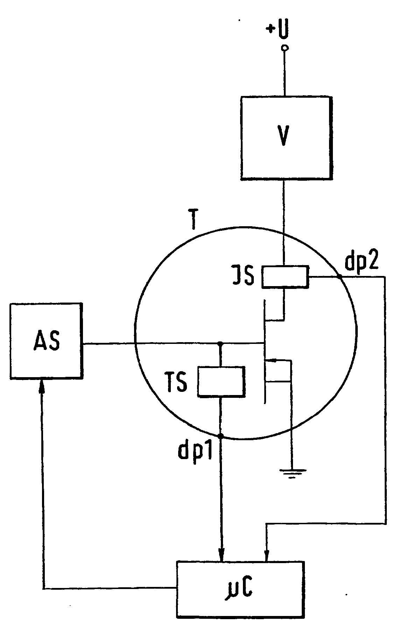

## Patentansprüche

1. Schutzschaltung für einen Leistungshalbleiter, der einen integrierten Sensor zum Überwachen eines Betriebsparameters auf Überlastung und zum Abschalten des Power-MOS-FET beim Erreichen oder Überschreiten eines vorgegebenen Überlastwertes des Betriebsparameters aufweist und den Abschaltezustand auf einem Diagnoseausgang anzeigt,
**dadurch gekennzeichnet,**
**dass** der Sensor (TS, JS) bei einem Wert des Betriebsparameters, der einen vorgegebenen Betrag unterhalb des Überlastwertes liegt, auf dem Diagnoseausgang (dp1, dp2) ein Vorwarnsignal abgibt, das sich vom Abschaltsignal unterscheidet, und
**dass** das Vorwarnsignal einem Mikrokontroller (µC) zugeführt wird, der die Ansteuerung des Leistungshalbleiters (T) in vorgegebener Weise kontrolliert weiterführt und/oder verzögert beendet.

2. Schutzschaltung nach Anspruch 1,
**dadurch gekennzeichnet,**
**dass** der Sensor (TS) als Temperatursensor ausgebildet ist.

3. Schutzschaltung nach Anspruch 1,
**dadurch gekennzeichnet,**
**dass** der Sensor (JS) als Lastsensor ausgebildet ist.

4. Schutzschaltung nach einem der Ansprüche 1 bis 3,
**dadurch gekennzeichnet,**
**dass** im Ruhezustand und im Abschaltzustand des Sensors (TS, JS) auf dem Diagnoseausgang (dp1, dp2) unterschiedliche, statische Signale ("0" und "1") anstehen und
**dass** als Vorwarnsignal ein getaktetes Signal ansteht.

5. Schutzschaltung nach einem der Ansprüche 1 bis 4,
**dadurch gekennzeichnet,**
**dass** der Leistungshalbleiter (T) mehrere unterschiedliche Sensoren (TS und JS) enthält, die auf getrennte Diagnoseausgänge (dp1, dp2) oder einen gemeinsamen Diagnoseausgang arbeiten.

6. Schutzschaltung nach einem der Ansprüche 1 bis 5,
**dadurch gekennzeichnet,**
**dass** ein im Taktbetrieb gesteuerter Leistungshalbleiter mit dem Auftreten des Vorwarnsignals über den Mikrokontroller (µC) vorzugsweise zeitlich begrenzt im Dauerbetrieb ansteuerbar und dann abschaltbar ist.

7. Schutzschaltung nach Anspruch 6,
**dadurch gekennzeichnet,**
**dass** mit dem Auftreten des Abschaltsignals auch der Mikrokontroller (µC) eine weitere Ansteuerung des Leistungshalbleiters (T) beendet.

8. Schutzschaltung nach einem der Ansprüche 1 bis 7,
**dadurch gekennzeichnet,**
**dass** die Ansprechwerte für die Sensoren (TS, JS) zur Abgabe eines Vorwarnsignals durch eine externe Beschaltung des Leistungshalbleiters (T) einstellbar ist.

## Claims

1. Protection circuit for a power semiconductor which has an integrated sensor for monitoring an operating parameter with regard to overloading and for turning off the power MOS-FET when a predetermined overload value of the operating parameter is reached or exceeded, and which indicates the turn-off state on a diagnosis output,
**characterized**
**in that**, in the case of a value of the operating parameter which lies below the overload value by a predetermined magnitude, the sensor (TS, JS) outputs a prewarning signal on the diagnosis output (dp1, dp2), said prewarning signal differing from the turn-off signal, and
**in that** the prewarning signal is fed to a microcontroller (µC), by which the driving of the power semiconductor (T), in a predetermined manner, is continued in controlled fashion and/or ended in delayed fashion.

2. Protection circuit according to Claim 1,
**characterized**
**in that** the sensor (TS) is formed as a temperature sensor.

3. Protection circuit according to Claim 1,
**characterized**
**in that** the sensor (JS) is formed as a load sensor.

4. Protection circuit according to one of Claims 1 to 3,
**characterized**
**in that**, in the quiescent state and in the turn-off state of the sensor (TS, JS) different static signals ("0" and "1") are present on the diagnosis output (dp1, dp2), and
**in that** a clocked signal is present as the prewarning signal.

5. Protection circuit according to one of Claims 1 to 4,
**characterized**
**in that** the power semiconductor (T) contains a plurality of different sensors (TS and JS) which operate at separate diagnosis outputs (dp1, dp2) or a common diagnosis output.

6. Protection circuit according to one of Claims 1 to 5,
**characterized**
**in that** a power semiconductor controlled in clock operation, with the occurrence of the prewarning signal, can be driven in continuous operation by means of the microcontroller (µC) preferably in temporally limited fashion and can then be turned off.

7. Protection circuit according to Claim 6,
**characterized**
**in that**, with the occurrence of the turn-off signal, the microcontroller (µC) also ends a further driving of the power semiconductor (T).

8. Protection circuit according to one of Claims 1 to 7,
**characterized**
**in that** the response values for the sensors (TS, JS) for outputting a prewarning signal can be set by means of an external circuitry of the power semiconductor (T) .

## Revendications

1. Circuit de protection pour un semi-conducteur de puissance, comprenant un détecteur intégré pour surveiller un paramètre de fonctionnement du point de vue de la surcharge et pour déconnecter le MOSFET de puissance lorsque l'on atteint ou dépasse une valeur de surcharge prédéterminée du paramètre de fonctionnement et qui affiche l'état de déconnexion sur une sortie de diagnostic,
**caractérisé en ce que**
le détecteur (TS, JS) émet sur la sortie de diagnostic (dp1, dp2), pour une valeur du paramètre de fonctionnement se situant à un niveau prédéterminé en dessous de la valeur de surcharge, un signal d'avertissement qui se distingue du signal de coupure, et
le signal d'avertissement est envoyé à un microcontrôleur (µC) qui, d'une manière prédéterminée, transmet de façon contrôlée la commande du semi-conducteur de puissance (T) et/ou qui la termine avec retard.

2. Circuit de protection selon la revendication 1,
**caractérisé en ce que**
le détecteur (TS) est un capteur de température.

3. Circuit de protection selon la revendication 1,
**caractérisé en ce que**
le détecteur (JS) est un capteur de charge.

4. Circuit de protection selon l'une quelconque des revendications 1 à 3,
**caractérisé en ce qu'**
à l'état de repos et à l'état déconnecté du détecteur (TS, JS), il y a des signaux statiques différents ("0" et "1") sur la sortie de diagnostic (dp1, dp2), et
un signal cadencé est présent en guise de signal d'avertissement.

5. Circuit de protection selon l'une quelconque des revendications 1 à 4,
**caractérisé en ce que**
le semi-conducteur de puissance (T) contient plusieurs détecteurs (TS et JS) différents, qui travaillent sur des sorties de diagnostic séparées (dp1, dp2) ou sur une sortie de diagnostic commune.

6. Circuit de protection selon l'une quelconque des revendications 1 à 5,
**caractérisé en ce qu'**
un semi-conducteur de puissance commandé en fonctionnement cadencé peut être commandé en fonctionnement permanent de préférence de façon limitée dans le temps et ensuite déconnecté par le microcontrôleur (µC) lors de l'apparition du signal d'avertissement.

7. Circuit de protection selon la revendication 6,
**caractérisé en ce que**
le microcontrôleur (µC) termine également une autre commande du semi-conducteur de puissance (T) lors de l'apparition du signal de coupure.

8. Circuit de protection selon l'une quelconque des revendications 1 à 7,
**caractérisé en ce que**
les seuils de réponse pour les détecteurs (TS, JS) en vue de l'émission d'un signal d'avertissement sont réglables par une ligne externe du semi-conducteur de puissance (T).
